(19)

Europäisches Patentamt
European Patent Office
Office européen des brevets

(11) **EP 1 884 984 B1**

(12) **EUROPEAN PATENT SPECIFICATION**

(45) Date of publication and mention of the grant of the patent:
**25.05.2011 Bulletin 2011/21**

(51) Int Cl.:
*H01L 21/00* (2006.01)   *H01J 37/05* (2006.01)
*G01R 27/26* (2006.01)

(21) Application number: **07109872.7**

(22) Date of filing: **08.06.2007**

(54) **Ion analysis system based on analyzer of ion energy distribution using retarded electric field**

Ionenanalysesystem auf der Grundlage eines Analysemittels für Ionenenergieverteilung unter Benutzung eines retardierten elektrischen Feldes

Système d'analyse d'ions basé sur un analyseur de distribution d'énergie d'ions utilisant un champ électrique retardé

(84) Designated Contracting States:
**DE FR GB**

(30) Priority: **04.08.2006 KR 20060073711**

(43) Date of publication of application:
**06.02.2008 Bulletin 2008/06**

(73) Proprietor: **Samsung Electronics Co., Ltd.**
**Gyeonggi-do 442-742 (KR)**

(72) Inventors:
• **Lee, Yung Hee**
  **Yeontong-gu, Suwon-si, Gyeonggi-do (KR)**
• **Ushakov, Andrey**
  **Yeongtong-gu, Suwon-si, Gyeonggi-do (KR)**
• **Tolmachev, Yuri**
  **Yeongton-gu, Suwon-si, Gyeonggi-do (KR)**

• **Volynets, Vladimir**
  **Yeongtong-gu, Suwon-si, Gyeonggi-do (KR)**
• **Pak, Won Ceak**
  **Seoul (KR)**
• **Pashkovskiy, Vasily**
  **Yongin-si, Gyeonggi-do (KR)**

(74) Representative: **Land, Addick Adrianus Gosling et al**
  **Arnold & Siedsma**
  **Sweelinckplein 1**
  **2517 GK Den Haag (NL)**

(56) References cited:
  **EP-A- 0 734 044**      **US-A- 5 451 784**
  **US-A1- 2006 043 063**  **US-B1- 6 326 794**

EP 1 884 984 B1

## Description

The present general inventive concept relates to an ion analysis system as a diagnostic apparatus, which can measure an ion energy distribution at several points on a surface of a semiconductor substrate during a process of manufacturing a semiconductor circuit, for example, a process including etching the semiconductor substrate to form features having submicron sizes thereon and doping the semiconductor substrate with an intensive ion beam. When ions collide against the substrate, energy and momentum of the ions have a high influence on sputtering, etching, and deposition ratios of thin films on the substrate. For an understanding of such ion impact effects on the process, it is necessary to obtain various energy distribution characteristics of the ions colliding against the surface of the substrate.

The present general inventive concept relates to a diagnostic apparatus that can be used to measure an ion energy distribution function at several points on a platen on which the semiconductor substrate is mounted, and which does not obstruct or influence a state of generating bulk plasma, electric potential, or gas flow. In other words, the platen does not contact any of the bulk plasma, the electric potential, or the gas flow. Since an ion analyzer according to embodiments of the present general inventive concept employs a retarded electric potential mesh, which has openings of 50 micrometers or less, the ion analyzer employs a plurality of small ion sensors. It is possible to install the plural (at least two) sensors in a radial direction (i.e., along a line extending away from a central axis of the platen) and an azimuth direction (i.e., along a horizontal angular distance with respect to the central axis of the platen) at the same time, and thus the ion energy distribution function can be measured in the radial direction and the azimuth direction.

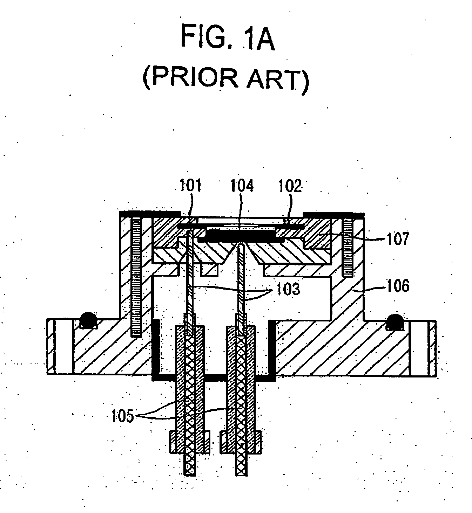

FIG. 1A is a view illustrating a structure of a conventional ion analyzer. The conventional analyzer generally includes retarded grids 101 and 102, current nodes 103, an ion flux collector 104, cables 105, an insulator 106, and an analyzer body 107. The conventional ion analyzer has an effective diameter of about 50 mm, which is generally adopted in several designs.

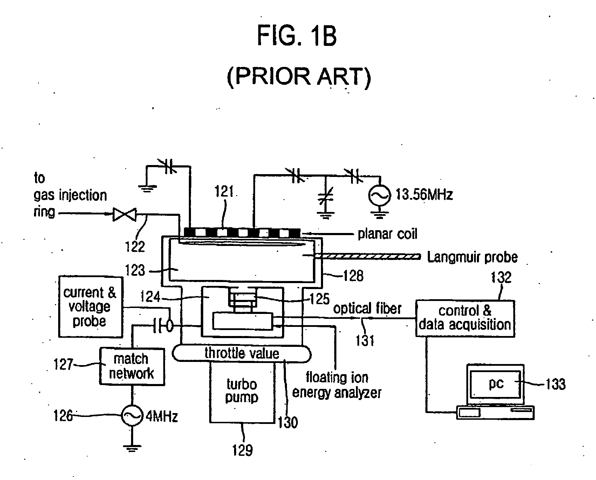

FIG. 1B is a schematic view illustrating an example of a conventional ICP (induction-coupled plasma) reactor.

The conventional ion analyzer of FIG. 1A is positioned in the conventional ICP reactor generally illustrated in FIG. 1B. The conventional ICP reactor includes an inductively coupled (or optionally, conductively coupled) plasma source 121 (which includes a planar coil), a gas injection ring (system) 122 to supply a reaction gas into a vacuum reaction chamber 128, a reactor volume section 123, and a pedestal 124 in which a substrate and an analyzer 125 (which includes a floating ion energy analyzer) are installed. Since the pedestal 124 is connected to a power supply 126 via a matching network (system) 127 (which includes a current and voltage probe), a biased voltage serves to cause an extraction of an ion flux from plasma in the conventional ICP reactor. The vacuum reaction chamber 128 is connected to a turbo molecular pump 129 through a throttle valve 130.

The conventional ion analyzer is connected to a personal computer 133 and a system 132 for controlling and obtaining data (control and data acquisition) via optical fibers 131. The optical fibers 131 enables a removal of a DC voltage, which is applied from a measurement circuit to the retarded grids 101 and 102 and is in the form of a high voltage bias electric potential.

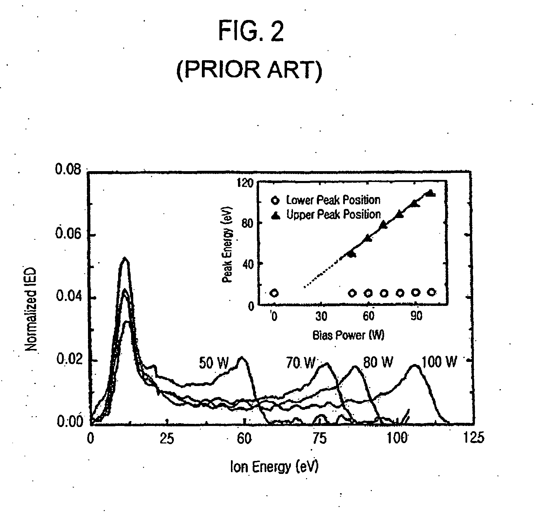

Fig. 2 is a view illustrating a representative example of ion spectrums obtained with various bias powers in argon plasma at 4 MHz and 5 mTorr using the conventional ion analyzer illustrated in FIG. 1A. From FIG. 2, it can be understood that, after measuring an ion energy distribution (IED), it is possible to forecast an effect of an ion flux on a semiconductor substrate at various powers of a bias system. In addition, it is possible to estimate functions of a high energy component with respect to a low energy component. This is important for application of plasma doping, during which a significant amount of accelerated ions is obtained on a surface of the semiconductor substrate.

In a process of manufacturing semiconductor devices, there has been a consistent requirement for local and accurate data related to parameters for the semiconductor manufacturing process.

For example, to achieve an etching uniformity, it is necessary to control energy and distribution of ions. In this regard, however, there is a problem in that nonuniformity in radial etching or axial etching occurs.

The energy and momentum of the ions colliding against the substrate have a high influence on sputtering, etching, and deposition ratios of thin films as well as on a development of surface shapes. In some cases, an estimated difference in an average electric potential per time between the plasma and electrodes indicates the energy of the ions colliding against the substrate. Hence, due to advantageous parameters indicating the ion energy, a parametric investigation is generally performed using such an average electric potential. For a basic understanding of ion impact effects on the process of treating the surface of the substrate, it is necessary to obtain various energy distribution characteristics of the ions colliding against the surface of the substrate in various states of the plasma.

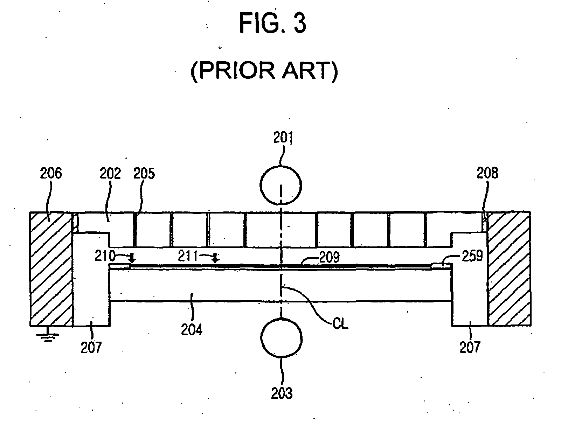

FIG. 3 is a view illustrating a typical configuration of a conventional CCP (capacitively coupled plasma) reactor used for etching. The CCP reactor includes an RF (radio frequency) plasma supply, which has a matching circuit 201, and a gas transfer system 202, which serves to transfer reaction gas into a vacuum chamber while acting as an electric potential electrode coupled to plasma. In addition, the CCP reactor includes a bias RF power source 203, a pedestal 204 on which a substrate is mounted, a gas inlet 205, a (grounded) chamber wall 206, a chamber pump 207, and an insulator 208.

Reference numerals 209, 210, and 211 denote a processed substrate 209 (200 or 300 mm according to a general manufacturing process), a point 210 of an edge of the substrate 209, and a point 211 near the center of the substrate 209, respectively. Reference mark CL denotes a central axis of the CCP reactor. Reference numeral 259 denotes a Silicon (Si) focus ring 259, which is positioned in front of the substrate 209 outside the substrate 209 to equalize an electric potential of an outer case.

One problem of a diagnostic device for the conventional CCP reactor is that the diagnostic device has a significantly limited capability due to a small gap, for example, a distance of approximately 25 to 35 mm, between the gas transfer system 202 and the pedestal 204 as illustrated in FIG. 3. In this case, a contact plasma diagnosis method cannot be applied thereto, since the contact plasma diagnosis method can distort plasma and/or since a probe (such as the Langmuir probe illustrated in FIG. 1 B) for this method has a size approaching approximately 6 to 10 mm, which is similar to the distance of the gap, causing an arc in the gap of the CCP reactor. Therefore, it is necessary to provide a beneficial non-contact type method, which can provide information to accurately and locally exhibit a state of etching. For example, since a sampling system of the diagnostic device cannot be positioned at the point 210 or at the two points 210 and 211 as illustrated in FIG 3, the sampling system of the diagnostic device has an outer diameter of about 50 mm. This structure makes the above method disadvantageous in terms of process analysis.

As such, in spite of its small size, the diagnostic device cannot be applied to the above method because the diagnostic device is incapable of measuring the ion distribution at one or more points. This restricts an efficiency of the diagnostic device as a measurement tool.

Another problem of the diagnostic device is that, since a new type of CCP plasma etching reactor has separate electrodes, for example, a central electrode and an edge electrode to which power is supplied from two independent RF supplies, it is necessary to independently adjust plasma by analyzing ion fluxes emitted from a center and an edge of the CCP reactor.

US-A-6,326,794 discusses in-situ monitoring of plasma processes using a capacitance sensor mounted on an electrode. The pre-characterising portions of the appended claims are based on this document. US-A-5,451,784 discusses a placebo wafer with combined ion current probes and ion energy analyzers at various locations on the wafer. EP-A-0734044 discusses an ion energy analyzer having a microchannel plate whose geometric filtering characteristics are electrically controlled. US-A-2006/0043063 discloses a diagnostic plasma probe comprising ion sensors arranged both horizontally and vertically within a cavity

According to the present invention there is provided an apparatus according to claim 1. Preferred features of the invention will be apparent from the dependent claims, and the description which follows.

The present general inventive concept provides an ion analysis system, which can measure an ion energy distribution spectrum at various locations on a semiconductor substrate from a position mounted with the semiconductor substrate or a position near the mounted semiconductor substrate within an industrial plasma reactor used in etching and doping operations on the semiconductor substrate.

The present general inventive concept also provides an ion analysis system, which can measure an ion energy distribution function in a radial and/or azimuth direction using several similar ion flux sensors. This system is useful at least since there is no conventional method to understand an effect by various powers and frequencies when a reactor includes separate electrodes. The ion analysis system can be applied to reactive ion etching and plasma doping processes, which require an understanding of energy parameters of ion fluxes. It should be noted, however, that the ion analysis system can also be applied to other techniques, which require knowledge of the ion energy distribution function at a number of points within a reactor. Additional aspects and advantages of the present general inventive concept will be set forth in the description, or may be learned by practice of the invention.

The foregoing and/or other aspects and utilities of the present general inventive concept may be achieved by providing an ion analysis system, including a reaction chamber in which a semiconductor manufacturing process is performed to form a semiconductor circuit or a portion thereof, and an ion analyzer positioned within the reaction chamber to measure ion energy distribution, the ion analyzer including a plurality of ion flux sensors positioned at a corresponding plurality of locations within the reaction chamber such that ion fluxes generated in the reaction chamber are induced into the ion flux sensors and to measure an ion energy distribution in real time using the induced ion fluxes.

The ion analysis system may further include a pedestal configured to allow the ion flux sensors to be installed inside the pedestal.

Each of the ion flux sensors may include an inlet through which the ion flux is induced into the ion flux sensor, a plurality of electrodes, and at least one opening formed at the inlet to prevent the inlet from being shielded or closed.

The opening may be flush with an upper surface of the pedestal.

The opening may have a size approaching a Debye length thereof to prevent the opening from obstructing a change of an electric potential.

The plural electrodes may include upper and lower grids disposed near the opening, each of the grids being formed on a surface with a plurality of cells, and a size of each cell being smaller than the Debye length.

The size of each cell may be 50 micrometers or less, and each cell may be a general grid cell or mesh cell.

The plurality of ion flux sensors may include at least two ion flux sensors disposed in a radial direction with respect to a central axis of the reaction chamber to measure ion energy spectrums in the radial direction.

The plurality of ion flux sensors may include at least two ion flux sensors disposed in an azimuth direction with respect to a central axis of the reaction chamber to measure ion energy spectrums in the azimuth direction.

The ion analysis system may further include a power source to apply an RF-biased voltage to the ion flux sensors to be used in the semiconductor manufacturing process.

The pedestal may have an upper surface formed from silicon.

The foregoing and/or other aspects and utilities of the present general inventive concept may also be achieved by providing an ion analysis system, including a plasma reactor in which a semiconductor manufacturing process is performed to form a semiconductor circuit or a portion thereof, an ion analyzer positioned within the reaction chamber to measure an ion energy distribution at a plurality of locations in real time using ion fluxes generated within the reaction chamber, a control unit to convert data of the ion energy distribution measured by the ion analyzer into a digital signal, a computer having software to analyze measurement data converted into the digital data by the controller in real time to output an error or alarm message based on an analysis result, and a reactor controller to control the plasma reactor in response to the error or alarm message transmitted from the computer.

The ion analyzer may include a plurality of the ion flux sensors to measure an energy distribution, and each of the ion flux sensors may include a cylindrical body having a base and a wall, at least two grids formed from a conductive material, at least one ion collector formed from a conductive material, and nodes mounted on a socket connected to a retarded voltage source and a diagnostic cable, the at least two grids and the ion collector mounted on respective ones of the nodes within the cylindrical body.

The ion analysis system may further include a pedestal on which the ion flux sensors are mounted, the pedestal and the ion flux sensors being positioned within the plasma reactor.

The plurality of ion flux sensors may include at least two ion flux sensors disposed in a radial direction with respect to a center of the pedestal.

The plurality of ion flux sensors may include at least two ion flux sensors disposed in an azimuth direction with respect to a center of the pedestal.

The foregoing and/or other aspects and utilities of the present general inventive concept may also be achieved by providing a method of manufacturing a semiconductor circuit or a portion thereof in a reaction chamber, inducing ion fluxes generated in the reaction chamber into a plurality of ion flux sensors positioned at a corresponding plurality of locations in the reaction chamber, and measuring an ion energy distribution in real time using the induced ion fluxes.

The foregoing and/or other aspects and utilities of the present general inventive concept may also be achieved by providing a method of manufacturing a semiconductor, the method including forming a semiconductor circuit or a portion thereof in a plasma reactor, measuring an ion energy distribution at a plurality of locations in the plasma reactor in real time using ion fluxes generated within the plasma reactor by an ion analyzer positioned within the plasma reactor, converting data of the ion energy distribution measured by the ion analyzer into a digital signal, analyzing measurement data converted into the digital data in real time to output an error or alarm message based on an analysis result, and controlling the plasma reactor in response to the output error or alarm message.

The foregoing and/or other aspects and utilities of the present general inventive concept may also be achieved by providing an ion analysis system, including a plasma reaction chamber to process a semiconductor substrate using an ion beam, a pedestal disposed in the plasma reaction chamber to support the substrate, the pedestal having an edge portion and a central portion, and an ion analyzer disposed in the plasma reaction chamber to measure an ion energy distribution at the edge portion and/or the central portion of the pedestal.

The ion analyzer may include at least one ion flux sensor to analyze ion fluxes emitted from the edge portion and/or the central portion of the pedestal. The at least one ion flux sensor may include a cylindrical body having a sampling orifice, a plurality grids to receive an applied retarded electric potential, each grid including a plurality of cells, and an ion collector to receive ions that pass through the plurality of grids. Each cell of the plurality of cells may have a size of 50 $\mu$m or less.

The ion analysis system may further include a retarded voltage source to apply the retarded electric potential to the plurality of grids, a plurality of grid nodes to which corresponding ones of the plurality of grids are mounted, a collector node to which the ion collector is mounted, and a socket to electrically-connect the retarded voltage source with the plurality of grid nodes and the collector node. The plurality of grids may include a lower electron retardation grid to reject electrons falling from the ion collector, and an upper sampling grid including a series of sample openings to sample ions colliding against the pedestal. The plurality of grids and the ion collector may be electrically insulated from each other. A size of each of the plurality of cells may be smaller than a size of the sampling orifice. A diameter of the cylindrical body may be about 25 mm or less.

The at least one ion flux sensor may include at least one edge sensor to analyze ion fluxes emitted from the edge portion of the pedestal, and at least one central sensor to analyze ion fluxes emitted from the central portion of the pedestal. The ion analysis system may further include at least one edge electrode disposed near the edge portion of the pedestal, and at least one central electrode disposed near the central portion of the pedestal. The ion analysis system may further include a first power source to power the at least one edge electrode, and a second power source different from the first power source to power the at least one central electrode.

These and/or other aspects and advantages of the present general inventive concept will become apparent and more readily appreciated from the following description of the embodiments, taken in conjunction with the accompanying drawings, of which:

FIG. 1A is a view illustrating a structure of a conventional ion analyzer;

FIG. 1B is a view illustrating a conventional ICP plasma reactor;

FIG. 2 is a view illustrating ion spectrums obtained by the conventional ion analyzer of FIG. 1;

FIG. 3 is a view illustrating a conventional CCP plasma reactor;

FIG. 4 is a view illustrating an ion flux sensor, according to an embodiment of the present general inventive concept;

FIG. 5 is a SEM micrograph illustrating a grid structure of the ion flux sensor of FIG. 4, according to an embodiment of the present general inventive concept;

FIG. 6A is a view illustrating one example of an ion analysis system, according to and embodiment of the present general inventive concept, in which ion flux sensors are installed within a plasma reactor;

FIG. 6B is a view illustrating another example of an ion analysis system, according to an embodiment of the present general inventive concept, in which ion flux sensors are installed within a plasma reactor;

FIG. 7 is a view illustrating an arrangement of ion flux sensors in the ion analysis system of FIG. 6B, according to an embodiment of the present general inventive concept; and

FIG. 8 is a view illustrating a semiconductor manufacturing process line including an ion analysis system, according to an embodiment of the present general inventive concept.

Reference will now be made in detail to the embodiments of the present general inventive concept, examples of which are illustrated in the accompanying drawings, wherein like reference numerals refer to the like elements throughout. The embodiments are described below to explain the present general inventive concept by referring to the figures.

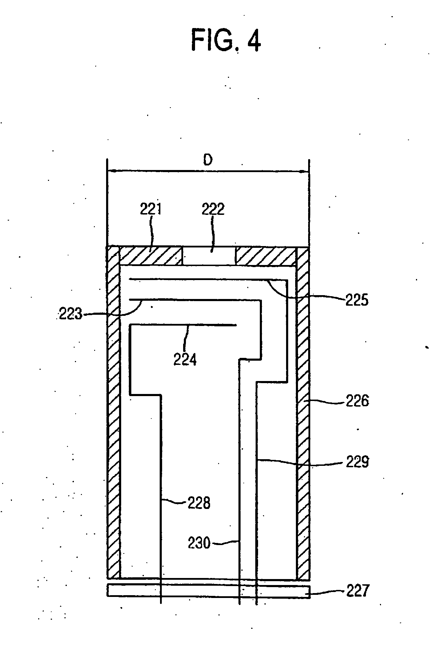

An ion analyzer according to embodiments of the present general inventive concept may include at least two ion flux sensors combined in a single ion analysis system to measure an ion energy distribution function. Fig. 4 is a view illustrating an ion flux sensor as one essential component of an ion analyzer according to an embodiment of the present general inventive concept.

The ion flux sensor of FIG. 4 includes a cylindrical body, which is constituted by two sections, that is, a base 221 and a wall 226. The cylindrical body may have a predetermined diameter D. The base 221 of the cylindrical body is formed with an opening 222. The ion flux sensor may further include a plurality of grids 223 and 225 to which retarded electric potential is applied. The number of grids can be changed according to designs. In the drawings, the two grids 223 and 225 are illustrated according to the present embodiment; however, the present general inventive concept is not limited to the two grids 223 and 225. The ion flux sensor may further include an ion collector 224 to which ions are transferred after passing through the grids 223 and 225.

The grids 223 and 225 and the ion collector 224 may be formed from a conductive material, and mounted on nodes 230, 229, and 228, respectively. The nodes 228, 229 and 230 may be mounted on a socket 227 to which a retarded voltage source and a diagnostic cable are connected.

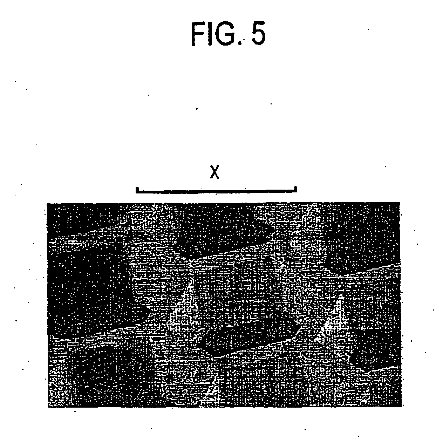

In the cylindrical body of the ion flux sensor according to the present embodiment, each grid 223 and 225 is formed on a surface thereof with a plurality of cells, each of which may have a size of 50 micrometers or less (see "X" in FIG. 5). The size of 50 micrometers is selected to form a grid size much less than a size of the opening 222, which may have a diameter of, for example, about 0.5 mm to about 1 mm. In this case, there may be, for example, about 1- to about 20 cells in front of an inlet (not illustrated) of the ion flux sensor.

FIG. 5 is a SEM (scanning electron microscopy) micrograph illustrating one example of a grid structure of the ion flux sensor of FIG. 4, according to an embodiment of the present general inventive concept.

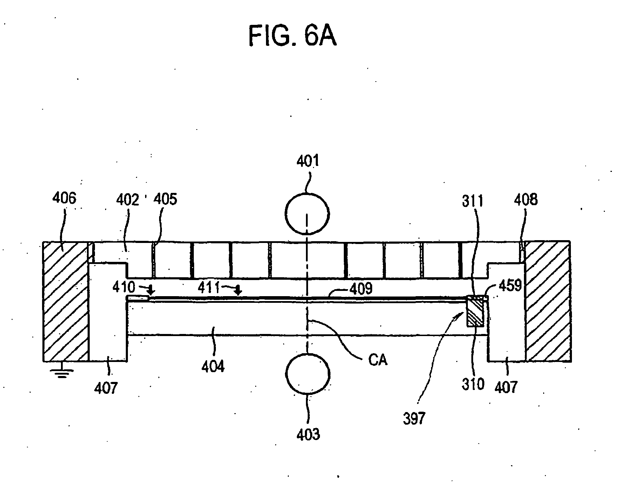

FIG. 6A is a view illustrating one example of an ion analysis system, according to an embodiment of the present general inventive concept. The ion analysis system includes an RF (radio frequency) plasma supply including a matching circuit 401 and a gas transfer system 402 to transfer reaction gas into a vacuum chamber while acting as an electric potential electrode coupled to plasma. In addition, the ion analysis system includes a bias RF power source 403, a pedestal 404 on which a substrate is mounted, a gas inlet 405, a chamber wall 406 (which can be grounded), a chamber pump 407, and an insulator 408. The ion analysis system may also include a processed substrate 409 (200 or 300 mm according to a general manufacturing process), a point 410 of an edge of the substrate 409, and a point 411 near the center of the substrate 409. Reference mark CA denotes a central axis of the ion analysis system. The ion analysis system may also include a focus ring 459, which may be a silicon (Si) focus ring 459. The focus ring 459 may be positioned in front of the substrate 409 and outside of the substrate 409 to equalize an electric potential of an outer case.

In the ion analysis system according to the present embodiment, an ion flux sensor 397 having a sampling orifice is installed to have an upper surface 311 flush with the focus ring 459 in a state wherein a body 310 of the ion flux sensor 397 and other sensors are positioned inside the pedestal 404 to prevent the ion flux sensor 397 and the other sensors from interfering with plasma on the focus ring 459. The ion flux sensor 397 of FIG. 6A may be the same as the ion flux sensor of FIG. 4.

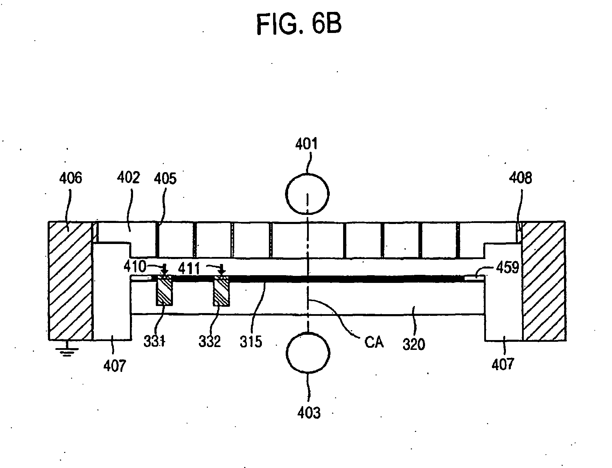

FIG. 6B is a view illustrating another example of an ion analysis system, according to an embodiment of the present general inventive concept. The ion analysis system of FIG. 6B is similar to the ion analysis of FIG. 6A with the following differences. In the ion analysis system of FIG. 6B, first and second ion flux sensors 331 and 332 are installed radially on a cross-section of a reactor within a pedestal 320, which is provided with an upper plate 315 formed of an electrically conductive material and having a similar shape to an upper surface of the pedestal 409 formed of silicon. The pedestal 320 is provided as an electrostatic chuck used in the semiconductor manufacturing industry, and may include other components that can separate the chuck from the upper plate 315 via a dielectric layer. Diagnostic tools and the first and second ion flux sensors 331 and 332 having sampling orifices flush with the upper plate 315 of the pedestal 320 are positioned inside the pedestal 320, and are used without disturbing a distribution of an electric field on the pedestal 315. The ion flux sensors 331 and 332 may be the same as the ion flux sensor of FIG. 4.

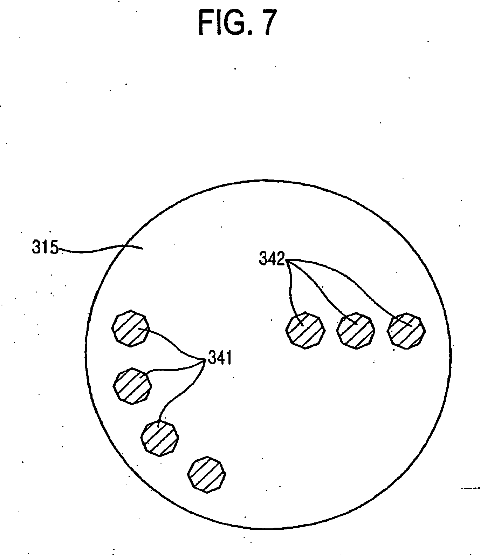

FIG. 7 is a plan view illustrating one example of an arrangement of ion flux sensors in the ion analysis system of FIG. 6B, according to an embodiment of the present general inventive concept. FIG. 7 illustrates a first group of ion flux sensors 342 arranged in a radial direction and a second group of ion flux sensors 341 arranged in an azimuth direction on the upper plate 315. With this arrangement, an angular ion energy distribution function and/or a radial ion energy distribution function can be measured.

Meanwhile, since a variation in time and space of an electric field on electrodes determines an energy distribution of ions colliding against the electrodes, it is important to ensure that an opening of an ion flux sensor (such as the opening 222 of FIG. 4) does not disturb a variation of an electric potential. Such a disturbance can be avoided by using small openings, such as sampling orifices. However, if a size of the opening of the ion flux sensor (such as the opening 222 of FIG. 4) is too small, the too small opening may restrict an ionic current, and may degrade a ratio of noise to signal. It is desirable that the a size of a grid opening of a grid (such as a size of an opening of grids 223, 224, and/or 225 of FIG. 4) approaches a Debye length thereof (i.e., a distance over which significant charge separation can occur). In this case, a distortion caused by the electric field can be minimized in front of the grid (or grids).

The Debye length may be, for example, about 30 micrometers to about 70 micrometers in a capacitively coupled plasma (CCP) reactor. Here, the Debye length $\lambda_p$ can be defined by $\lambda_p = 7430\sqrt{\overline{T_e n_e}}\,(m)$, where $T_e$ = about 1 eV to about 5 eV and $n_e = 5 \times 10^{16}$ m$^{-3}$. The grids 223 and 225 of the ion flux analyzer of FIG. 4 may be reduced in size to, for example, 70 micrometers or less. FIG. 5 illustrates one example of a hexagonal grid cell having a size of 50 micrometers. In this case, the size of the grid cell in FIG. 5 is less than the Debye length thereof, thereby lowering a possibility of plasma leakage into the ion flux analyzer of FIG. 4.

The diameter D of the cylindrical body of the ion flux sensor of FIG. 4 may be about 25 mm or less. The ion flux sensor of FIG. 4 may be positioned inside a pedestal of an ion analysis system (e.g., the pedestal 404 of FIG. 6A or the pedestal 320 of FIG. 6B) below the focus ring 459 so as not to disturb plasma and gas flow within the ion analysis system while preventing adverse influence on other components of the system. In this case, it is important to ensure ion fluxes can be measured when a treated substrate is positioned at this location with respect to the ion flux sensor. A value of 25 mm is determined when the focus ring 459 has a width of about 15 mm to about 30 mm for the ion analysis system used to etch a wafer of about 200 mm to about 300 mm. Other examples of techniques to manufacture the grid can be easily obtained by one of ordinary skill in the art.

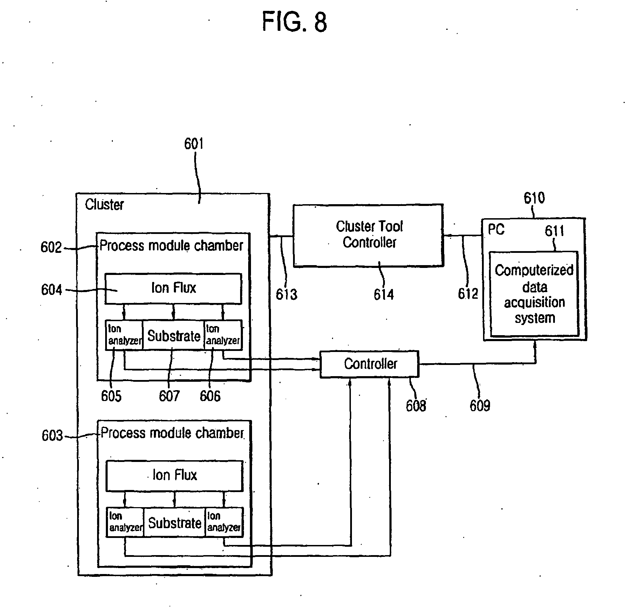

FIG. 8 is a view illustrating a semiconductor manufacturing process line including an arrangement of components of an ion analysis system, according to an embodiment of the present general inventive concept.

Among layouts installed in the process line illustrated in FIG. 8, a cluster 601 may include a plurality of process chambers (process module chambers) 602 and 603 in which some or all semiconductor circuits are processed by an ion flux (such as an ion flux 604 of the process chamber 602 in FIG. 8). In each of the process chambers 602 and 603, ion analyzers (such as ion analyzers 605 and 606 of the process chamber 602 in FIG. 8) may be positioned near a semiconductor substrate (such as a semiconductor substrate 607 of the process chamber 602 in FIG. 8) such that ion energy distribution functions measured by the ion analyzers (such as the ion analyzers 605 and 606) are the same as ion energy distribution functions of ions used to process the semiconductor substrate (such as the semiconductor substrate 607). The ion analysis system may further include an ion analyzer controller 608 to convert an analog data into a digital data in response to a data protocol. Digital data 609 is collected by a data acquisition system 611, which includes a storage space to store collected data and a personal computer (PC) 610 in which software 611 is installed for data acquisition and analysis in real time.

After analyzing the digital data 609 obtained in real time, the personal computer 610 compares the analyzed data with a preset data. When a result of the comparison of the analyzed data with the preset data satisfies a predetermined condition (which may be determined by a control program), the personal computer 610 generates an error or alarm message 612 on a cluster tool controller 614 of another computer which serves to control clusters of several process modules and equipment to load, unload, pump, and to perform other operations. The cluster tool controller 614 generates a control signal 613 on the process chambers (such as the process chambers 602 and 603) in order to correct an operation state of the process chambers in real time in sequence.

An ion energy analyzer to measure an ion energy distribution of ions colliding against an RF biased substrate should be designed to accept several essential requirements. First, the ion energy analyzer should be suitably designed with respect to an electrostatic chuck of a conductively coupled plasma reactor without causing a severe change in a reaction chamber of the reactor. Second, since a spatial restriction removes a possibility of differentially pumping the ion analyzer, a mean free path of ions induced into the ion analyzer should be longer than a distance from a sampling orifice to a detector in order to prevent a collision inside the ion analyzer. Third, the sampling orifice should be designed to minimize a disturbance to an electric field of the plasma near the sampling orifice while maintaining a proper sampling area to maximize ionic current. Fourth, since the ion analyzer is bought into contact with RF biased electrodes, the ion energy analyzer should be in a floating state, and electronics should be designed to detect a small electric potential added to an RF bias of several volts. Details of electronics and measurement circuits are not disclosed herein, and a detailed process of measuring an ion energy distribution function can be easily obtained by one of ordinary skill in the art.

As illustrated in FIG. 4, an ion beam analyzer according to an embodiment of the present general inventive concept may include two grids 223 and 225 (lower grid 223 and upper grid 225) and a single collector plate 224. The upper grid 225 is at the same potential as the electrode and provides a series of openings to sample the ions colliding against the surface of the electrostatic chuck. The lower grid 223 is biased at a negative electric potential of, for example, about 100 V to about 500 V with respect to the upper grid 225, and serves to reject the electrons falling from the collector plate 224. The upper sampling grid 225, the lower electron rejection grid 223, and the collector plate 224 may be electrically insulated from each other via vacuum spaces, since there is no electric contact therebetween. The upper sampling grid 225, the lower electron rejection grid 223, and the collector plate 224 may be connected to the corresponding nodes, 229, 230, and 228, which are mounted on a dielectric (ceramic) plate and have sufficient spaces between the nodes 229, 230, and 228 to prevent electric contact therebetween.

An operation pressure may be in a range of about 5 mTorr to about 30 mTorr, which corresponds to a mean free path of ions in a range of about 2 mm to about 12 mm. Therefore, a distance between the upper sampling grid 225 and the collector plate 224 is much smaller than s mean free path of ions at an operation pressure of a reactor. The collector plate 224 is positioned below the lower electron retardation grid 223, which acts as both an ion collector and an ion energy detector. An ion energy distribution function is determined by ramping up the electric potential applied to the collector plate 224 with respect to the electric potential of the electrodes and measuring an electric current collected by the collector plate 224 as a function of the applied electric potential, and is proportional to a derived function of current-voltage characteristics as measured in this manner.

The nodes 228, 229 and 230 electrically connected to the grids 223 and 225 and the collector plate 224 are connected to the socket 227, and a contact may be, for example, a gold plated spring contact. The opening 222 acts as an exit port of gas induced into the ion flux analyzer. A grid size and a distance between the wall 226 of the ion flux analyzer and each of the grids 223 and 225 are determined to minimize a pressure difference between a housing of the ion flux analyzer and a plasma chamber while maximizing an electrical conductivity. The ion flux analyzer illustrated in FIG. 4 can be inserted into a pedestal of a plasma reactor (such as the ion analysis system of FIG. 6A or 6B) through a center or an edge thereof. One or more ion flux analyzers as illustrated in FIG. 4 may be inserted into the pedestal (such as the pedestal 404 of FIG. 6A or the pedestal 320 of FIG. 6B).

FIGS. 6A and 6B are view illustrating different examples of an ion analysis system including one or more ion flux sensors, according to embodiments of the present general inventive concept. In FIG. 6A, the ion flux sensor 397 is installed to measure an ion energy spectrum of ion fluxes directed towards the substrate 409.

Electronics are provided to bias the grids 223 and 225 (see FIG. 4) to ramp an electric potential of the collector plate 224 (see FIG. 4) and to measure a current and voltage. The electronics may be incorporated and integrated into a circuit board of a single stack. The stack of the integrated electronics may be affixed to a bottom of an analyzer capsule (not illustrated) immediately below a pedestal (such as the pedestal 404 of FIG. 6A or the pedestal 320 of FIG. 6B) and may be surrounded by a metal box (not illustrated). The metal box and the electronics may be floated with respect to a ground, and RF biased electrodes may be used as the ground.

Thus, an electrical potential of the metal box may be changed along with that of a substrate electrode, and all DC electric potentials may be applied on the basis of this electric potential. Power to operate the electronics is insulated, amplified, filtered, and rectified into an output DC voltage via a transformer (not illustrated).

For the electronics, it is necessary to control and monitor an electric potential and current in the electron rejection grid 223 and the collector plate 224 (see FIG. 4). The transformer supplies a voltage of, for example, about 200 V to about 30,000 V to the electron rejection grid 223 and the collector plate 224. Control and data acquisition of the ion flux analyzer are performed through a communication board within the stack of the incorporated electronics (not illustrated). A separate outer communication board connects the communication board in the stacks of the electronics to, for example, a data acquisition card of the personal computer 610 (see FIG. 8), which can employ control programs to control and collect Lab-View data, via an interface. The outer board and the inner communication board of the ion flux analyzer may include a series of transformers of voltage to frequency and of frequency to voltage, which are driven by a square wave transmitted by a light emitting diode (not illustrated) and detected by a solid optical sensor (not illustrated).

An optical cable may be provided for communication between the ion flux analyzer and the outer board. This enables the control and data acquisition without any electrical connection between the ion flux analyzer and the grounded electronic components. Detailed description of an electronic circuit therebetween will not be disclosed herein, and one of ordinary skill in the art can easily obtain information about a method of fabricating an electronic circuit, which can control and operate the ion flux analyzer.

In FIG. 8, after a signal is transmitted from the ion analyzers 605 and 606 to the controller 608, the digital signal 609 can be transmitted from the controller 608 to the computerized data acquisition system 611, which includes the computer 610 having the associated software for data acquisition and analysis in real time. The ion analysis system of FIG. 8 generates the error or alarm message 612 on the cluster tool controller 614. This message is read by an operator or automatically transmitted as a control signal 613 to the associated process module 602 in real time, thereby allowing the process to be corrected in real time.

As apparent from the above description, an ion analysis system according to embodiments of the present general inventive concept can measure an ion energy distribution function at several points on a surface of a substrate. Furthermore, the ion analysis system does not adversely influence a semiconductor manufacturing process. With ion analyzers incorporated into a control system of a semiconductor process line, the ion analysis system allows measured ion energy spectrums to be analyzed on a data acquisition system. Moreover, the ion analysis system enables a state of the process to be controlled by an operator or associated software based on an error or alarm message that is transmitted to an interface of a cluster tool controller.

In addition, the ion analysis system enables an influence of ion fluxes on manufacturing characteristics to be understood. When ions collide against a substrate, energy and momentum of the ions have a high influence on sputtering, etching, and deposition ratios of thin films on the substrate. To understand such ion impact effects on the process, it is desirable to obtain various energy distribution characteristics of the ions colliding against the surface of the substrate. The ion analyzer may be installed outside the substrate, and may measure ion energy distribution at a region near an edge of the substrate. In this case, it is possible to control and monitor the ion energy distribution in various states in an actual process.

An ion analysis system according to embodiments of the general inventive concept can be applied to a plasma doping process. In particular, the ion analysis system can be applied to the plasma doping process in the same manner as in the etching process. Ion flux sensors of several analyzers are positioned at different locations in order to allow the analyzers to employ several channels. For the plasma doping system, it is important to control the same energy distribution function in real time with respect to a substrate to be doped.

According to the present invention there is provided an apparatus and method as set forth in the appended claims. Preferred features of the invention will be apparent from the dependent claims, and the description which follows.

Attention is directed to all papers and documents which are filed concurrently with or previous to this specification in connection with this application and which are open to public inspection with this specification, and the contents of all such papers and documents are incorporated herein by reference.

All of the features disclosed in this specification (including any accompanying claims, abstract and drawings), and/or all of the steps of any method or process so disclosed, may be combined in any combination, except combinations where at least some of such features and/or steps are mutually exclusive.

Each feature disclosed in this specification (including any accompanying claims, abstract and drawings) may be replaced by alternative features serving the same, equivalent or similar purpose, unless expressly stated otherwise. Thus, unless expressly stated otherwise, each feature disclosed is one example only of a generic series of equivalent or similar features.

The invention is not restricted to the details of the foregoing embodiment(s). The invention extends to any novel one, or any novel combination, of the features disclosed in this specification (including any accompanying claims, abstract and drawings), or to any novel one, or any novel combination, of the steps of any method or process so disclosed.

## Claims

1. An ion analysis system, comprising:

   a reaction chamber (602) of a CCP reactor in which a semiconductor manufacturing process is performed on a substrate to form a semiconductor circuit or a portion thereof;
   a pedestal (404) to support the substrate; and
   an ion analyzer (605) positioned within the reaction chamber (602) to measure an ion energy distribution, the ion analyzer (605) comprising a plurality of ion flux sensors (397) positioned at a corresponding plurality of locations within the reaction chamber (602) such that ion fluxes (604) generated in the reaction chamber (602) are induced into the ion flux sensors (397) and to measure an ion energy distribution in real time using the induced ion fluxes (604);
   each of the plurality of sensors (397) comprising:

   an inlet (221) through which the ion flux is induced into the ion flux sensor (397);
   a plurality of electrodes (223, 225), **characterized in that** the plurality of electrodes (223, 225) comprises upper and lower grids (223, 225) disposed near the opening (222), each of the grids (223, 225) being formed on a surface with a plurality of cells, and a size of each cell being smaller than the Debye length $X_p$ between 30 and 70 micrometers; **in that** at least one opening (222) is formed at the inlet (221) to be configured to prevent the inlet (221) from being shielded or closed, wherein each of the openings (222) has a size approaching a Debye length thereof to prevent the opening (222) from obstructing a change of an electric potential; and **in that**
   the pedestal (404) is configured to have the ion flux sensors (397) installed inside the pedestal (404) with openings (222) flush with an upper surface of the pedestal (404).

2. The ion analysis system according to claim 1, wherein the size of each cell is 50 micrometers or less, and each cell is a general grid cell or mesh cell.

3. The ion analysis system according to claim 1 or 2, wherein the plurality of ion flux sensors (397) comprises:

   at least two ion flux sensors (397) disposed in a radial direction with respect to a central axis of the reaction chamber (602) to measure ion energy spectrums in the radial direction.

4. The ion analysis system according to claim 1, 2 or 3, wherein the plurality of ion flux sensors (397) comprises:

   at least two ion flux sensors (397) disposed in an azimuth direction with respect to a central axis of the reaction chamber (602) to measure ion energy spectrums in the azimuth direction.

5. The ion analysis system according to any of claims 1-4, further comprising:

   a power source to apply a RF-biased voltage to the ion flux sensors (397) to be used in the semiconductor manufacturing process.

6. The ion analysis system according to any of claims 1-5, wherein the pedestal (404) has an upper surface formed from silicon.

7. The ion analysis system of any preceding claim, further comprising:

   a control unit (614) to convert data of the ion energy (30) distribution measured by the ion analyzer (397) into a digital signal;
   a computer (610) having software to analyze measurement data converted into the digital data by the controller in real time to output an error or alarm message based on an analysis result; and
   a reactor controller (614) to control the plasma reactor (602) in response to the error or alarm message transmitted from the computer.

8. The ion analysis system according to any preceding claim, wherein each of the ion flux sensors (397) comprises:

   a cylindrical body having a base and a wall,
   at least two grids (223, 225) formed from a conductive material,
   at least one ion collector formed from a conductive material, and
   nodes mounted on a socket connected to a retarded voltage source and a diagnostic cable,
   wherein the at least two grids (223, 225) and the ion collector are mounted on respective ones of the nodes within the cylindrical body.

9. The ion analysis system according to any of claims 1-8, wherein the plurality of ion flux sensors (397) comprises:

   at least two ion flux sensors (397) disposed in a radial direction with respect to a center of the pedestal (404).

10. The ion analysis system according to any of claims 1-9, wherein the plurality of ion flux sensors (397) comprises:

> at least two ion flux sensors (397) disposed in an azimuth direction with respect to a center of the pedestal (404).

11. The ion analysis system of any of claims 8-10, wherein the pedestal (404) has an edge portion and a central portion; and
the ion flux sensors (397) are disposed in the plasma reaction chamber (602) to measure an ion energy distribution at the edge portion and/or the central portion of the pedestal (404).

12. The ion analysis system according to claim 11, wherein the ion flux sensors are arranged to analyze ion fluxes (604) emitted from the edge portion and/or the central portion of the pedestal (404).

13. The ion analysis system according to claim 12, wherein the at least one ion flux sensor (397) comprises:

> a cylindrical body having a sampling orifice;
> a plurality grids (223, 225) to receive an applied retarded electric potential, each grid including a plurality of cells; and
> an ion collector to receive ions that pass through the plurality of grids (223, 225).

14. The ion analysis system according to claim 13, further comprising:

> a retarded voltage source to apply the retarded electric potential to the plurality of grids (223, 225);
> a plurality of grid nodes to which corresponding ones of the plurality of grids (223, 225) are mounted;
> a collector node to which the ion collector is mounted; and
> a socket to electrically-connect the retarded voltage source with the plurality of grid nodes and the collector node.

15. The ion analysis system according to claim 13 or 14, wherein the plurality of grids (223, 225) comprises:

> a lower electron retardation grid to reject electrons falling from the ion collector; and .
> an upper sampling grid including a series of sample openings to sample ions colliding against the pedestral (404).

16. The ion analysis system according to any of claims 13-15, wherein a size of each of the plurality of cells is smaller than a size of the sampling orifice.

**Patentansprüche**

1. Ionenanalysesystem, umfassend:

> eine Reaktionskammer (602) eines CCP, in der ein Halbleiterherstellungsprozess auf einem Substrat durchgeführt wird, um eine Halbleiterschaltung oder einen Abschnitt davon zu bilden;
> einen Sockel (404), um das Substrat zu tragen; und
> einen innerhalb der Reaktionskammer (602) positionierten Ionenanalysator (605), um eine Ionenenergieverteilung zu messen, wobei der Ionenanalysator (605) eine Mehrzahl von Ionenflusssensoren (397) umfasst, die an einer entsprechenden Mehrzahl von Stellen innerhalb der Reaktionskammer (602) so positioniert sind, dass in der Reaktionskammer (602) erzeugte Ionenflüsse (604) in die Ionenflusssensoren (397) induziert werden, und um eine Ionenenergieverteilung in Echtzeit mittels der induzierten Ionenflüsse (604) zu messen;
> wobei jeder aus der Mehrzahl von Sensoren (397) umfasst:

> > einen Einlass (221), durch den der Ionenfluss in den Ionenflusssensor (397) induziert wird;
> > eine Mehrzahl von Elektroden (223, 225), **dadurch gekennzeichnet, dass** die Mehrzahl von Elektroden (223, 225) obere und untere Gitter (223, 225)umfasst, die nahe der Öffnung (222) angeordnet sind, wobei jedes der Gitter (223, 225) auf einer Fläche mit einer Mehrzahl von Zellen geformt ist, und eine Größe jeder Zelle kleiner ist als die Debye-Länge $X_p$ zwischen 30 und 70 Mikrometern; dass
> > zumindest eine Öffnung (222) am Einlass (221) geformt ist, die ausgebildet ist, um zu verhindern, dass der Einlass (221) abgeschirmt oder verschlossen wird, wobei jede der Öffnungen (222) eine Größe aufweist, die sich einer Debye-Länge davon annähert, um zu verhindern, dass die Öffnung (222) eine Veränderung eines elektrischen Potentials behindert; und dass
> > der Sockel (404) so ausgebildet ist, dass die Ionenflusssensoren (397) im Inneren des Sockels (404) angebracht sind, wobei Öffnungen (222) auf einer Ebene mit einer oberen Fläche des Sockels (404) liegen.

**2.** Ionenanalysesystem nach Anspruch 1, wobei die Größe jeder Zelle 50 Mikrometer oder weniger beträgt, und jede Zelle eine gewöhnliche Gitterzelle oder Maschenzelle ist.

**3.** Ionenanalysesystem nach Anspruch 1 oder 2, wobei die Mehrzahl von Ionenflusssensoren (397) umfasst:

zumindest zwei Ionenflusssensoren (397), die in einer radialen Richtung in Bezug auf eine Mittelachse der Reaktionskammer (602) angeordnet sind, um Ionenenergiespektren in der radialen Richtung zu messen.

**4.** Ionenanalysesystem nach Anspruch 1, 2 oder 3, wobei die Mehrzahl von Ionenflusssensoren (397) umfasst:

zumindest zwei Ionenflusssensoren (397), die in einer Azimutrichtung in Bezug auf eine Mittelachse der Reaktionskammer (602) angeordnet sind, um Ionenenergiespektren in der Azimutrichtung zu messen.

**5.** Ionenanalysesystem nach einem der Ansprüche 1 - 4, das weiterhin umfasst:

eine Energiequelle, um eine RF-Biased-Spannung an die Ionenflusssensoren (397) zu legen, die im Halbleiterherstellungsprozess zu verwenden sind.

**6.** Ionenanalysesystem nach einem der Ansprüche 1 - 5, wobei der Sockel (404) eine aus Silizium gebildete obere Fläche aufweist.

**7.** Ionenanalysesystem nach einem der vorstehenden Ansprüche, das weiterhin umfasst:

eine Steuerungseinheit (614), um vom Ionenanalysator (397) gemessene Daten der Ionenenergie-(30)-Verteilung in ein digitales Signal umzuwandeln;
einen Rechner (610) mit Software, um vom Controller in die digitalen Daten umgewandelte Messdaten in Echtzeit zu analysieren, um auf Grundlage eines Analyseergebnisses eine Fehler- oder Alarmmeldung auszugeben; und
einen Reaktorcontroller (614), um den Plasmareaktor (602) in Reaktion auf die aus dem Rechner gesendete Fehler- oder Alarmmeldung zu steuern bzw. zu regeln.

**8.** Ionenanalysesystem nach einem der vorstehenden Ansprüche, wobei jeder der Ionenflusssensoren (397) umfasst:

einen zylindrischen Körper mit einer Grundfläche und einer Wand,
zumindest zwei aus einem leitenden Material geformte Gitter (223, 225),
zumindest einen aus einem leitenden Material geformten Ionenfänger, und
Knoten, die auf einem Anschlusssockel angebracht sind, der an eine Quelle retardierter Spannung und ein Diagnostikkabel angeschlossen ist,
wobei die zumindest zwei Gitter (223, 225) und der Ionenfänger auf jeweiligen der Knoten innerhalb des zylindrischen Körpers angebracht sind.

**9.** Ionenanalysesystem nach einem der Ansprüche 1 - 8, wobei die Mehrzahl von Ionenflusssensoren (397) umfasst:

zumindest zwei Ionenflusssensoren (397), die in einer radialen Richtung in Bezug auf eine Mitte des Sockels (404) angeordnet sind.

**10.** Ionenanalysesystem nach einem der Ansprüche 1 - 9, wobei die Mehrzahl von Ionenflusssensoren (397) umfasst:

zumindest zwei Ionenflusssensoren (397), die in einer Azimutrichtung in Bezug auf eine Mitte des Sockels (404) angeordnet sind.

**11.** Ionenanalysesystem nach einem der Ansprüche 8 - 10, wobei der Sockel (404) einen Randabschnitt und einen mittleren Abschnitt aufweist; und
die Ionenflusssensoren (397) in der Plasmareaktionskammer (602) angeordnet sind, um eine Ionenenergieverteilung an dem Randabschnitt und / oder dem mittleren Abschnitt des Sockels (404) zu messen.

**12.** Ionenanalysesystem nach Anspruch 11, wobei die Ionenflusssensoren angeordnet sind, um Ionenflüsse (604) zu analysieren, die von dem Randabschnitt und / oder dem mittleren Abschnitt des Sockels (404) ausgesendet werden.

**13.** Ionenanalysesystem nach Anspruch 12, wobei der zumindest eine Ionenflusssensor (397) umfasst:

einen zylindrischen Körper mit einer Sampleöffnung;
eine Mehrzahl von Gittern (223, 225), die ein angelegtes retardiertes elektrisches Potential erhalten, wobei jedes Gitter eine Mehrzahl von Zellen beinhaltet; und
einen Ionenfänger, der Ionen erhält, die die Mehrzahl von Gittern (223, 225) passieren.

**14.** Ionenanalysesystem nach Anspruch 13, das weiterhin umfasst:

eine Quelle retardierter Spannung, um das retardierte elektrische Potential an die Mehrzahl von Gittern (223, 225) zu legen;
eine Mehrzahl von Gitterknoten, an denen entsprechende aus der Mehrzahl von Gittern (223, 225) angebracht sind;
einen Fängerknoten, an dem der Ionenfänger angebracht ist; und
einen Anschlusssockel, um die Quelle retardierter Spannung elektrisch mit der Mehrzahl von Gitterknoten und dem Fängerknoten zu verbinden.

15. Ionenanalysesystem nach Anspruch 13 oder 14, wobei die Mehrzahl von Gittern (223, 225) umfasst:

ein unteres Elektronenretardationsgitter, um aus dem Ionenfänger fallende Elektronen abzustoßen; und
ein oberes Samplegitter, das eine Reihe von Sampleöffnungen beinhaltet, um gegen den Sockel (404) kollidierende Ionen zu sampeln.

16. Ionenanalysesystem nach einem der Ansprüche 13 - 15, wobei eine Größe jeder aus der Mehrzahl von Zellen kleiner ist als eine Größe der Sampleöffnung.

## Revendications

1. Système d'analyse ionique, comprenant :

une chambre réactionnelle (602) de CCP (Plasma à Couplage Capacitif) dans laquelle est réalisé un processus de fabrication d'un semi-conducteur sur un substrat afin de former un circuit semi-conducteur ou une partie de celui-ci ;
un socle (404) destiné à supporter le substrat ; et
un analyseur ionique (605) disposé à l'intérieur de la chambre réactionnelle (602) pour mesurer une répartition de l'énergie ionique, l'analyseur ionique (605) comprenant une pluralité de capteurs de flux ionique (397) disposés en une pluralité correspondante d'emplacements au sein de la chambre réactionnelle (602) de sorte que les flux ioniques (604) générés dans la chambre réactionnelle (602) soient induits dans les capteurs de flux ionique (397), et pour mesurer une répartition de l'énergie ionique en temps réel en utilisant les flux ioniques (604) induits ;

chaque capteur de la pluralité de capteurs (397) comprenant :

une entrée (221) à travers laquelle le flux ionique est induit dans le capteur de flux ionique (397) ;

une pluralité d'électrodes (223, 225), **caractérisées en ce que** la pluralité d'électrodes (223, 225) comprend des grilles supérieure et inférieure (223, 225) placées à proximité de l'ouverture (222), chacune des grilles (223, 225) comportant la formation, sur une surface, d'une pluralité de cellules, la taille de chaque cellule étant inférieure à la longueur de Debye $X_p$ allant de 30 à 70 micromètres ; et **en ce que** au moins une ouverture (222) est constituée à l'entrée (221) et est configurée pour empêcher que l'entrée (221) soit écrantée ou fermée, chacune des ouvertures (222) ayant une taille approchant une longueur de Debye de celle-ci afin d'empêcher que l'ouverture (222) n'obstrue une modification de potentiel électrique ; et **en ce que** le socle (404) est configuré pour que les capteurs de flux ionique (397) soient installés à l'intérieur du socle (404), les ouvertures (222) étant de niveau avec une surface supérieure du socle (404).

2. Système d'analyse ionique selon la revendication 1, dans lequel la taille de chaque cellule est de 50 micromètres ou moins, et chaque cellule est une cellule générale de grille ou de maille.

3. Système d'analyse ionique selon la revendication 1 ou 2, dans lequel la pluralité de capteurs de flux ionique (397) comprend :

au moins deux capteurs de flux ionique (397) placés dans une direction radiale par rapport à un axe central de la chambre réactionnelle (602) pour mesurer les spectres énergétiques ioniques dans la direction radiale.

4. Système d'analyse ionique selon la revendication 1, 2 ou 3, dans lequel la pluralité de capteurs de flux ionique (397) comprend :

au moins deux capteurs de flux ionique (397) placés dans une direction azimutale par rapport à un axe central de la chambre réactionnelle (602) pour mesurer les spectres énergétiques ioniques dans la direction azimutale.

5. Système d'analyse ionique selon l'une quelconque des revendications 1 à 4, comprenant en outre :

une source d'énergie destinée à appliquer une tension à polarisation RF aux capteurs de flux ionique (397) à utiliser dans le processus de fabrication de semiconducteurs.

6. Système d'analyse ionique selon l'une quelconque des revendications 1 à 5, dans lequel le socle (404) présente une surface supérieure constituée de silicium.

**7.** Système d'analyse ionique selon l'une quelconque des revendications précédentes, comprenant en outre :

une unité de commande (614) pour convertir les données de la distribution d'énergie (30) ionique mesurée par l'analyseur ionique (397) en un signal numérique ;
un ordinateur (610) pourvu d'un logiciel permettant d'analyser les données de mesure converties en données numériques par le contrôleur en temps réel pour émettre un message d'erreur ou d'alarme en fonction d'un résultat d'analyse ; et
un contrôleur (614) de réacteur permettant de contrôler le réacteur à plasma (602) en réaction au message d'erreur ou d'alarme émis par l'ordinateur.

**8.** Système d'analyse ionique selon l'une quelconque des revendications précédentes, dans lequel chacun des capteurs de flux ionique (397) comprend :

un corps cylindrique présentant une base et une paroi, au moins deux grilles (223, 225) constituées dans un matériau conducteur,
au moins un collecteur d'ions constitué dans un matériau conducteur, et
des noeuds montés sur une prise raccordée à une source de tension à retard et à un câble de diagnostique,
dans lequel les au moins deux grilles (223, 225) et le collecteur d'ions sont montés sur des noeuds respectifs à l'intérieur du corps cylindrique.

**9.** Système d'analyse ionique selon l'une quelconque des revendications 1 à 8, dans lequel la pluralité de capteurs de flux ionique (397) comprend :

au moins deux capteurs de flux ionique (397) placés dans une direction radiale par rapport à un centre du socle (404).

**10.** Système d'analyse ionique selon l'une quelconque des revendications 1 à 9, dans lequel la pluralité de capteurs de flux ionique (397) comprend :

au moins deux capteurs de flux ionique (397) disposés dans une direction azimutale par rapport à un centre du socle (404).

**11.** Système d'analyse ionique selon l'une quelconque des revendications 8 à 10, dans lequel le socle (404) présente une partie de bord et une partie centrale ; et les capteurs de flux ionique (397) sont disposés dans la chambre réactionnelle à plasma (602) pour mesurer une répartition de l'énergie ionique au niveau de la partie de bord et/ou de la partie centrale du socle (404).

**12.** Système d'analyse ionique selon la revendication 11, dans lequel les capteurs de flux ionique sont agencés pour analyser les flux ioniques (604) émis par la partie de bord et/ou la partie centrale du socle (404).

**13.** Système d'analyse ionique selon la revendication 12, dans lequel l'au moins un capteur de flux ionique (397) comprend :

un corps cylindrique présentant un orifice d'échantillonnage ;
une pluralité de grilles (223, 225) destinées à recevoir un potentiel électrique à retard appliqué, chaque grille comportant une pluralité de cellules ; et
un collecteur d'ions destiné à recevoir les ions traversant la pluralité de grilles (223, 225).

**14.** Système d'analyse ionique selon la revendication 13, comprenant en outre :

une source de tension à retard destinée à appliquer le potentiel électrique à retard à la pluralité de grilles (223, 225) ;
une pluralité de noeuds de grille sur lesquels sont montées des grilles correspondantes parmi la pluralité de grilles (223, 225) ;
un noeud de collecteur sur lequel est monté le collecteur d'ions ; et
une prise destinée à effectuer la connexion électrique de la source de tension à retard avec la pluralité de noeuds de grille et le noeud de collecteur.

**15.** Système d'analyse ionique selon la revendication 13 ou 14, dans lequel la pluralité de grilles (223, 225) comprend :

une grille inférieure de retard d'électron servant à refouler les électrons tombant du collecteur d'ions ; et
une grille supérieure d'échantillonnage comportant une série d'ouvertures d'échantillonnage pour échantillonner les ions venant en collision contre le socle (404).

**16.** Système d'analyse ionique selon l'une quelconque des revendications 13 a 15, dans lequel la taille de chacune des cellules de la pluralité de cellules est inférieure à la taille de l'orifice d'échantillonnage.

# FIG. 1A
## (PRIOR ART)

# FIG. 1B

## (PRIOR ART)

to
gas injection
ring

planar coil

Langmuir probe

13.56MHz

121

122

123

124

125

128

optical fiber

131

132

control &
data acquisition

current &
voltage
probe

127

match
network

throttle value

floating ion
energy analyzer

pc

133

126

4MHz

turbo
pump

130

129

FIG. 2
(PRIOR ART)

# FIG. 3

# (PRIOR ART)

# FIG. 4

FIG. 5

X

# FIG. 6A

## FIG. 6B

EP 1 884 984 B1

FIG. 7

22

# FIG. 8

**EP 1 884 984 B1**

## REFERENCES CITED IN THE DESCRIPTION

### Patent documents cited in the description

- US 6326794 A
- US 5451784 A
- EP 0734044 A
- US 20060043063 A